**Europäisches Patentamt**

**European Patent Office**

**Office européen des brevets**

(19)

(11) Publication number: **0 128 615**
**B1**

(12) # EUROPEAN PATENT SPECIFICATION

(45) Date of publication of patent specification: **04.03.87**

(51) Int. Cl.⁴: **H 04 N 3/15, H 01 L 27/14**

(21) Application number: **84200773.4**

(22) Date of filing: **29.05.84**

(54) Charge-coupled semiconductor device and image sensor device of high information density.

(30) Priority: **03.06.83 NL 8301977**

(43) Date of publication of application:
**19.12.84 Bulletin 84/51**

(45) Publication of the grant of the patent:
**04.03.87 Bulletin 87/10**

(84) Designated Contracting States:
**AT DE FR GB IT NL SE**

(56) References cited:
**US-A-3 909 803**
**US-A-4 178 614**

**IEEE TRANSACTIONS ON ELECTRON DEVICES, vol. ED-20, no. 6, June 1973, pages 535-541, New York, US; C.H. SEQUIN: "Interlacing in charge-coupled imaging devices"**

(73) Proprietor: **N.V. Philips' Gloeilampenfabrieken**
**Groenewoudseweg 1**
**NL-5621 BA Eindhoven (NL)**

(72) Inventor: **Boudewijns, Arnoldus Johannes Juliana**
**c/o INT. OCTROOIBUREAU B.V. Prof. Holstlaan 6**
**NL-5656 AA Eindhoven (NL)**
Inventor: **Collet, Marnix Guillaume**
**c/o INT. OCTROOIBUREAU B.V. Prof. Holstlaan 6**
**NL-5656 AA Eindhoven (NL)**

(74) Representative: **Houbiers, Ernest Emile Marie**
**Gerlach et al**
**INTERNATIONAAL OCTROOIBUREAU B.V. Prof.**
**Holstlaan 6**
**NL-5656 AA Eindhoven (NL)**

## Description

The invention relates to a charge-coupled semiconductor device comprising a semiconductor body in which at a major surface at least one charge transport channel is defined and which is provided at the same major surface with a system of electrodes at which for charge storage a reference signal can be supplied and for charge transport a clock signal can be supplied.

The devices mentioned also known as CCD's (Charge-Coupled Devices), are used in various fields of the technique, for example as a delay line or memory element. Especially in the field of image sensor devices, they are increasingly utilized.

The invention therefore relates more particularly to a charge-coupled image sensor device of the said kind, in which at a major surface a number of charge transport channels which are mutually separated are defined for charge transport from a radiation-sensitive part to a memory part.

Such image sensor devices are used in solid state cameras, in which the information stored in the memory part can be converted by electronic means into a television signal, but may also be temporarily stored, for example on a memory disk or memory tape.

An image sensor device of the said kind is known from US—Patent 3,909,803. In this specification is described a charge-coupled image sensor device for a four-phase transport, in which in the various image elements, which are defined by means of each time four electrodes, charge is collected alternately under each of the four electrodes. For this purpose, in a first exposure period charge is collected under a first set of electrodes and this charge is transferred after this operation by means of a suitable clock voltage variation at the electrodes to a memory part. Subsequently, in a second exposure period charge is collected under a second set of electrodes located beside the first set, which charge is then also transferred to a memory part. Subsequently, this takes place again under a third and a fourth set of electrodes. Due to the fact that in this manner integration always occurs separately under each set of electrodes, the resolution of such an image sensor device is increased. However, this improvement is partly eliminated again in that also charge carriers generated under the other electrodes are collected under the relevant electrode.

Moreover, this is at the expense of a considerably longer sensing time. After charge has been collected under the first set of electrodes, this charge has first to be drained to the memory part before charge can be collected under a next set. In the said embodiment, the sensing time is therefore approximately quadrupled. Moreover, the four integration periods occur so as to be separated in time so that in the memory part there is stored an image which is composed of scenes of four successive integration times.

The present invention has for its object to provide an image sensor device of the kind mentioned in the opening paragraph, in which the stored charge is transferred more efficiently to the memory part and which can be designed for different forms of multiphase transport.

More generally, it has for its object to provide a charge-coupled semiconductor device, especially a charge-coupled image sensor device, in which the information density is higher than in known devices.

The invention is based on the recognition of the fact that this can be achieved in that the electrodes producing the potential wells in the semiconductor body for collecting and storing charge are driven selectively.

For this purpose, a device according to the invention is characterized in that the semiconductor body is provided with switching elements, by which at separate groups of at least one electrode either the reference signal or the clock signal can be supplied.

Due to this step, in such a device the information density can be doubled. This means especially for an image sensor device according to the invention that both the radiation-sensitive part and the memory part can be realized on a considerably smaller semiconductor surface area. This can lead on the one hand to an increased yield, while on the other hand parts of the electronic control system, such as clock pulse generators and, if desired, amplifiers, can now be realized together with the image sensor device in one semiconductor body. Further, with the same surface area a larger number of image lines can be obtained, which renders the sensor device suitable for cameras of a higher resolution (high definition television).

A device according to the invention is operated by means of a method which is known *per se* from US—Patent 4,178,614. In the method described in this specification, electrodes of an electrodes of an electrode system forming part of a charge-coupled device are controlled directly from registers. If such an electrode system is realized, as is common practice, in a multilayer wiring system, due to differences in threshold voltage, under electrodes of different phases, variations can occur with the same operating voltages in the depth of the potential wells produced.

As a result, with the so-called interlacing, the integration behaviour for even lines, can differ from that for odd lines. Due to the fact that in a device according to the invention the electrodes of even and odd lines can be held during the integration period at different reference voltages, such a difference in integration behaviours can be eliminated.

The invention will now be described more fully with reference to a few embodiments and the accompanying drawing, in which:

Fig. 1 shows a diagrammatic representation of an image sensor device according to the invention which is controlled by a four-phase clock,

Fig. 2a is a diagrammatic cross-sectional view taken on part of the line II—II in fig. 1,

Figures 2b to 2k illustrate the operation of the device shown in Fig. 1,

Fig. 3 shows a switching element for the device shown in Fig. 1,

Fig. 4 shows a diagrammatic representation of an image sensor device controlled by a two-phase clock, while

Fig. 5a is a diagrammatic cross-sectional view taken on part of the line V—V in Fig. 4, and

Figures 5b to 5f illustrate the operation of the device shown in Fig. 4.

The Figures are schematic and not drawn to scale, whilst for the sake of clarity, in the cross-sections expecially the dimensions in the direction of thickness are greatly exaggerated. Semiconductor zones of the same conductivity type are generally cross-hatched in the same direction; in the Figures, corresponding parts are generally designated by the same reference numerals.

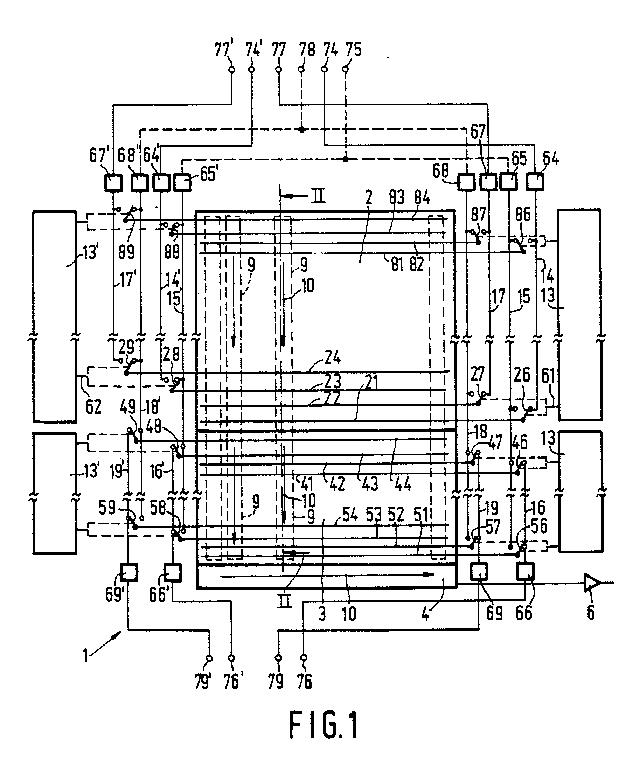

Fig. 1 shows the principle circuit diagram of an image sensing device 1 of the so-called frame-field transfer type. Such an image sensing device comprises a radiation-sensitive sensor part 2, in which during a given exposure period a pattern of electric charge carriers corresponding to the radiation image is formed. After the exposure period, the pattern of electric charge carriers is temporarily stored in the memory part 3, from which the pattern is sequentially read out by means of one or more shift registers 4. This reading-out operation can be effected by means of known techniques. If desired, the signals may be amplified before being further processed, by means of the amplifier 6 shown diagrammatically.

The image sensor device (Figures 1—2) comprises a semiconductor body 5 which is composed, for example of a silicon substrate 50 of the $n$-type having a resistivity of approximately 10 $\Omega$.cm (approximatly $5.10^{14}$ donor atoms/cm$^3$ and a $p$-type region 7 formed therein and having a doping of approximately $3.10^{15}$ acceptor atoms/cm$^3$. The $p$-type region 7 may be formed, for example, by means of ion implantation followed by a diffusion step. At the major surface 8 of the semiconductor body 5 a number of mutually separated substantially parallel extending charge transport channels (denoted in Fig. 1 by reference numeral 9) are defined, in which charge transport can take place, as indicated diagrammatically in Fig. 1 by arrows 10. In the present case, the charge transport device or CCD is constituted by a CCD with bulk transport (PCCD or BCCD). The charge transport channels are then constituted by $n$-tpe regions 11, which are mutually separated by $p$-type regions. The $n$-type regions in this embodiment have an average impurity concentration of approximately $10^{16}$ atoms/cm$^3$ and have a depth of about 1 $\mu$, while their width is approximately 5 $\mu$m.

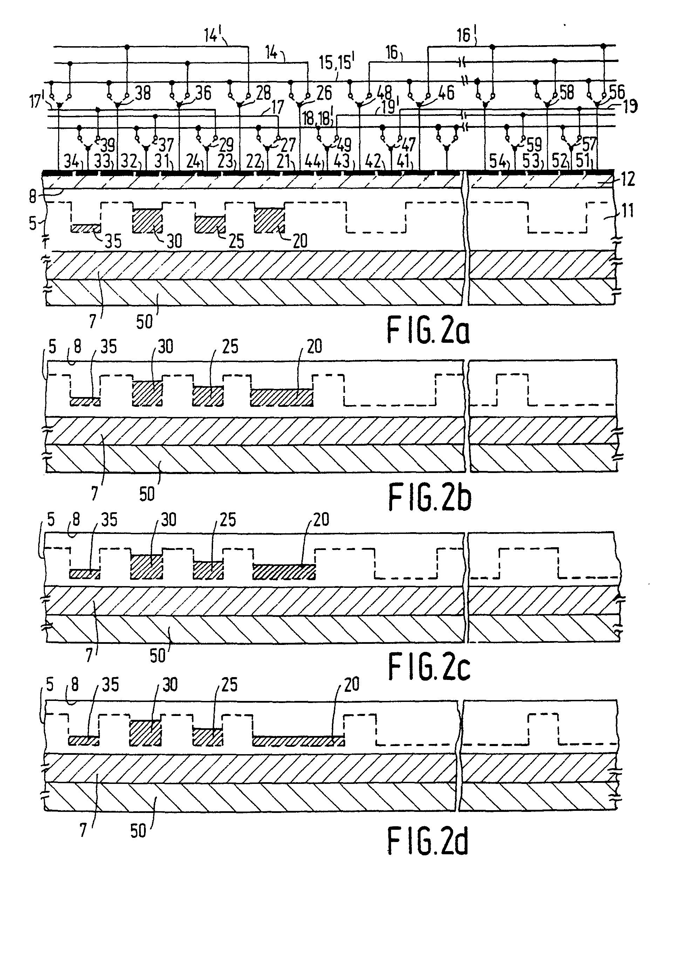

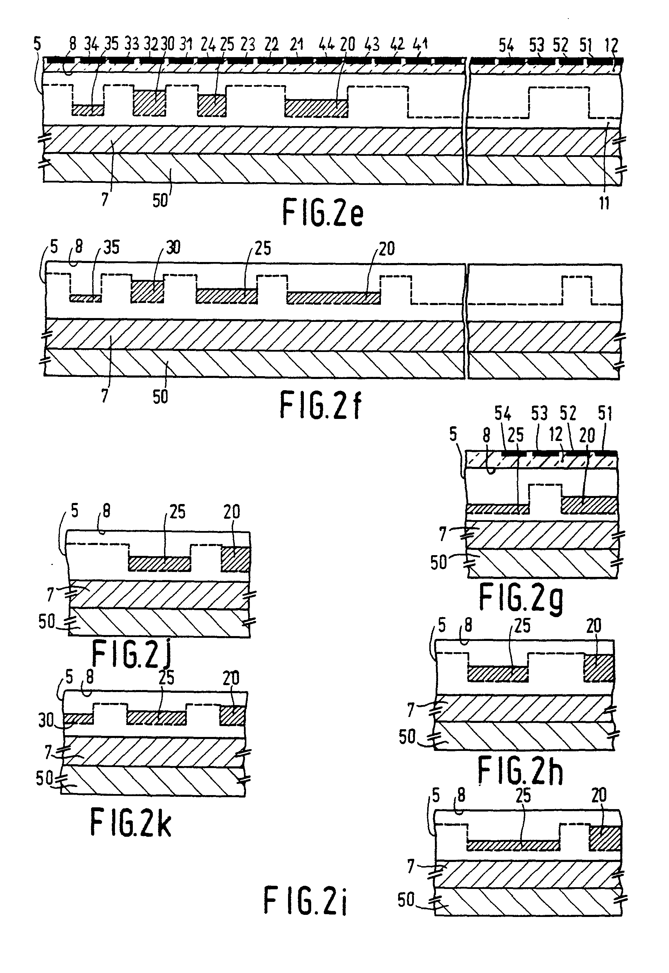

The major surface 8 (see Fig. 2) is covered by a layer 12 of insulating material, for example silicon oxide. On and in this insulating layer 12 are provided a number of electrodes, by means of which potential wells can be produced in the semiconductor material for charge storage and charge transport.

In the device of Fig. 2, which is suitable for four-phase transport, each so-called "storage element" in a channel 9, 11 of the sensor part 2 comprises four electrodes 21, 22, 23, 24 and 31, 32, 33, 34, respectively, which are common to "storage elements" in several channels. Similarly, in the memory part 3 such "storage elements" are formed by means of electrodes 41, 42, 43, 44 and 51, 52, 53, 54, respectively. As a matter of fact, the device comprises a considerably larger number of electrodes than is shown here. In an image sensor device for the so-called PAL system, both the sensor part and the memory part comprise approximately 600 electrodes, which corresponds to 150 "storage elements" per charge transport channel.

In the present embodiment comprising 600 electrodes, both in the sensor part and in the memory part, each of the electrodes can be switched so that a clock pulse or a storage signal (reference level) can be supplied. The device is provided for this purpose with switching elements 26, 27, 28, 29, 36, 37, 38, 39, 46, 47, 48, 49, 56, 57, 58, 59, by which the electrodes can be switched between signal lines 14, 16 and reference lines 15 and between signal lines 17, 19 and reference lines 18, respectively. The reference lines 15, 18 need not necessarily have a fixed potential; as will be explained more fully hereinafter, this reference potential is preferably adjustable.

The said switching elements are controlled from registers 13, 13'. When the electrodes at one wiring level are controlled alternately from registers 13' on the left-hand side and registers 13 on the right-hand side, the pitch of the registers (*i.e.* the distance between two successive outputs) can be approximately twice the pitch of the electrodes of one wiring level, which considerably simplifies the realization.

It is to be noted that each output of a register stage of the register 13, 13' each time controls simultaneously two switching elements and thus determines the behaviour of two electrodes; this in contrast with the device for four-phase transport as shown in the aforementioned US—Patent 4,178,614, in which each register stage controls one electrode. Therefore, the registers 13, 13' can be a factor 2 smaller than the registers shown therein. A further reduction is possible due to the fact that in the device of Fig. 1 the outputs of the register stage are loaded with only two switching elements (in this case gate electrodes), whereas in the device according to the said US Patent Specification each register stage is loaded with an electrode of the charge-coupled device, which can constitute especially in an image sensor device a considerable capacitive load.

For a better understanding, it is to be stated that in Fig. 1 the lines 15' and 18' may be driven, if desired, by the same signals as the lines 15 and 18, respectively. This may be effected externally in that these lines are connected *via* the connection points 65, 68 and 65', 68', respectively, to each other. In the present embodiment, such throughconnections are connected to connection points 75, 78 for reference signals.

In the device shown in Fig. 1, the clock pulse signals are supplied separately to the sensor part 2 and to the memory part 3. For the sensor part, the clock signal lines 14, 14', 17 and 17' are connected via connection points 64, 64', 67 and 67' to external connections 74, 74', 77 and 77' for a four-phase clock system. For the memory part, clock signal lines 16, 16', 19 and 19' are connected via connection points 66, 66', 69 and 69' to external connections 76, 76', 79 and 79', also for a four-phase clock system. If desired, the same connection points may be used to this end. Alternatively, the clock lines 14, 14', 17 and 17' may be throughconnected to the clock lines 16, 16' and 19, 19'. In the latter case, the connection points 66, 66', 69 and 69' as well as the connections 76, 76', 79 and 79' may be dispensed with.

The registers 13, 13', which control the switching elements 26, 27, 28, 29, 86, 87, 88, 89, 46, 47, 48, 49, 56, 57, 58, 59, are controlled, for example, by means of an auxiliary electronic system not shown further in the drawing, which for synchronization purposes may also be controlled by clock pulse signals at the connections 74, 76 and 74', 76', respectively or 77, 79 and 77', 79' respectively.

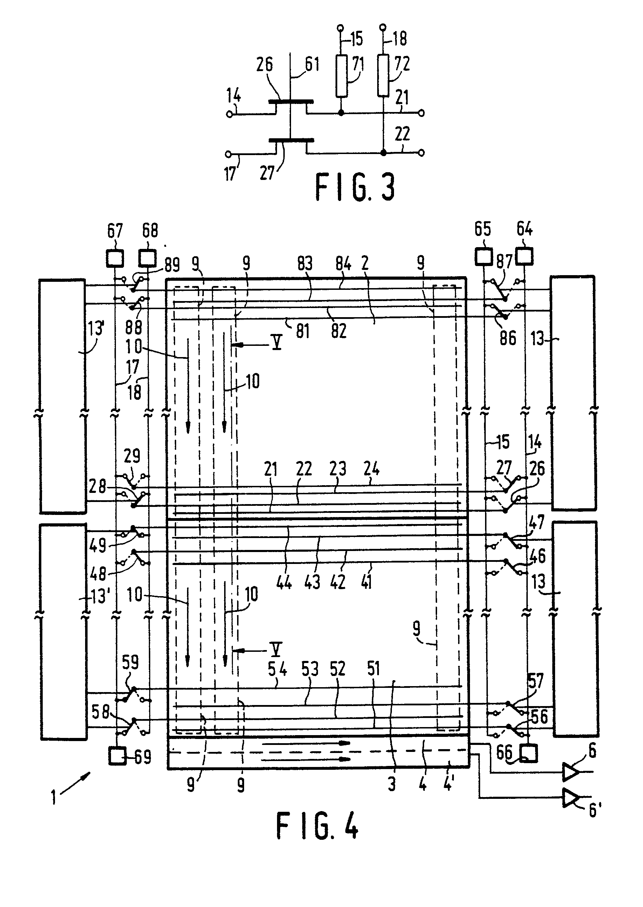

The switching elements 26, 27 may be constituted, for example, by MOS transistors, as is shown in Fig. 3 for the switching elements 26, 27. The n-MOS transistors are driven from the register 13 by means of a common gate electrode 61. When the signal or gate electrode is high, the transistors 26, 27 are conducting and the clock pulse signals, which are supplied via the source zones to the connections 14 and 17, are passed on to the electrodes 21, 22. In the manner, a four-phase clock can be supplied by means of the switching elements 26, 27, 28, 29, 36, 37, 38, 39, ... 86, 87, 88, 89 and 56, 57, 58, 59, ... 46, 47, 48, 49 via the common clock lines 14, 14', 17, 17' and 16, 16', 19, 19', respectively, at the electrodes 21, 22, 23, 24, 21, 32, 33, 34, ... 81, 82, 83, 84 and 51, 52, 53, 54 ... 41, 42, 43, 44, respectively, of the sensor part 2 and the memory part 3, respectively. When on the contrary the signal at the gate electrodes is low, the transistors 26, 27 are cut off and the potential at the electrodes 21, 22 is determined by the potential at the outputs of these transistors. This potential may be a fixedly adjusted voltage, but it may also be determined by means of adjustable signals at the lines 15, 18.

For further processing, the stored charge, which corresponds to a picked up image, is in fact generally converted into a signal for a television receiver. It is then usual to activate alternately the even and odd lines of the image screen. For this so-called interlacing, it is therefore desirable that within one image period (1/30—1/25 sec) a transfer takes place twice from the radiation-sensitive part to a storage register, the charge storage being effected alternately in different parts of the radiation-sensitive part. For this purpose, in the relevant image sensor device, the charge packets within one image period are alternately collected at different areas, i.e. alternately under the electrodes 21, 23, 31, 33 etc. and the electrodes 22, 24, 32, 34, etc., dependent upon the voltage at the lines 15, 15', 18, 18'.

The storage voltages (reference levels), which are used during the one integration period for integration under the electrodes 21, 23, 31, 33, . : ., need not be equal to those which are used during a next period for integration under the electrodes 22, 24, 32, 34, ... Due to the fact that these groups of electrodes are generally realized in different wiring layers, a difference in the threshold voltage and hence a difference in depth of the potential wells may occur. The integration behaviour is then not equal for both groups of electrodes. Dependent upon the extent of inequality, the connection points 65, 65', 68, 68' can now be furnished with different storage voltages. If the said inequality in integration behaviour is practically negligible, the connection point 65, 65' and 68, 68' can be commonly connected to external connections 75 and 77, respectively.

The operation of the image sensing device shown in Fig. 1 will now be described with reference to Fig. 2.

Fig. 2a shows the situation in one channel at the end of an integration period within the first half of an image period at an instant $t = 0$.

The integration has taken place under the electrodes 22, 24, 32, 34, ... 82, 84 in that they were connected via the switching elements 27, 29, 37, 39, ... 87, 89 to the reference lines 18, 18' which had a high voltage, while the electrodes 21, 23, 31, 33, ... 81, 83 were connected via the switching elements 26, 28, 36, 38 ... 86, 88 to the reference lines 15, 15' which had a low voltage.

The variation of the surface potential obtained due to the voltages at the transport electrodes in the semiconductor body is indicated by broken lines in Figures 2a to 2g. The potential variation is shown in a usual manner so that potential wells correspond to energy minima, so for electrons to parts of the semiconductor body which are situated under an electrode at high voltage. The broken line in Fig. 2a corresponds at least for the left-hand part to the potential variation as determined during the integration period by the fixed voltages at the electrodes 21, 22, 23, 24, 31, 32, 33, 34, ... 81, 82, 83, 84 in the sensor part. During the integration period, the charge packets 20, 25, 30 and 35 are collected under the electrodes 22, 24, 32 and 34, respectively. The electrodes 41, 42, 43, 44 and 51, 52, 53, 54 are connected via the switching elements 46, 47, 48, 49 and 56, 57, 58, 59 to the signal lines 16, 19, 16', 19' at which, as described above, a four-phase clock can be supplied. The broken line in the righthand half (memory part) of the device shown in Fig. 2a has the associated potential variation; such a clock pulse pattern is then supplied that at an instant $t = 0$ potential wells are situated under the electrodes 42, 43 and 52, 53, respectively, and corresponding electrodes in the memory part, while under the electrodes 41, 44 and 51, 54 and corresponding electrodes potential barriers are situated. The potential wells in the memory part are assumed to contain at the instant t = 0 no charge or at most a small quantity of charge due to noise.

It will be apparent from Fig. 2a that now two charge packets are collected under each "storage element" having a size of four electrodes in the sensor part 2 so that by means of 600 electrodes 300 charge packets per channel can be stored. This means for the image sensor part that in the preceding integration period 300 image lines are recorded in the image sensor part. With respect to the device as described in US—Patent 3,909,803, per integration period, with the same number of electrodes the double number of image lines is recorded. The use of switching elements also provides the possibility of shifting stored charge in two directions, which may have certain advantages in signal processing.

Fig. 2b shows the device at the instant $t_1 = 0.125 \mu\text{sec}$. when from a register 13 the switching elements 26 and 27 are switched *via* the control line 61 in such a manner that the electrodes 21 and 22 are connected to the clock lines 14 and 17, respectively, which in this embodiment are driven in the same manner as the clock lines 16 and 19. This results in that on the lefthand side of the electrode 22 (Fig. 2b) the potential variation in the semiconductor body remains unchanged, whereas this potential variations is determined on the righthand side of the electrode 23 by the clock pulse pattern at the signal lines 14, 17, 16, 19, 16' and 19'. This means that the voltage at the electrode 21 becomes high so that the width of the potential well for the charge packet 20 is effectively doubled. The associated charge is distributed over the potential well under the electrodes 21, 22. For the rest, in the part on the righthand side of the electrode 23 potential barriers are now present under the electrodes 44, 54 and corresponding electrodes.

At the lines 14, 17, 16, 19, 16', 19' such a clock pulse variation is supplied that at the instant $t_2 = 0.25 \mu\text{sec}$ the voltage at the electrodes 43, 53 and corresponding electrodes becomes low. The remaining electrodes retain the same voltage so that now potential barriers are present under the electrodes 43, 44 and 53, 54, respectively, and corresponding electrodes (see fig. 2c). The potential well under the electrodes 21, 22 is maintained so that the charge packet 20 remains in the same place.

At the instant $t_4 = 0.375 \mu\text{sec}$ only the electrodes 43, 53 and corresponding electrodes in the memory part have a low voltage so that only under these electrodes a potential barrier is present (see Fig. 2d). As a result, the charge packet 20 is distributed over a potential well located under the electrodes 22, 21 and 44.

At the instant $t_4 = 0.5 \mu\text{sec}$ the switching elements 28 and 29 are switched from the control register 13' *via* the control line 62 in such a manner that the electrodes 23 and 24 are connected to the clock lines 14' and 17', which are driven in the same manner as the clock lines 16' and 19'. As a result on the lefthand side of the electrode 24 the potential variation in the semiconductor body now remains unchanged, whereas this potential variation on the righthand side of the electrode 31 is determined by the clock pulse pattern at the signal lines 14, 17, 16, 19, 14', 17', 16' and 19'. Due to the clock pulse pattern, potential barriers are now formed in the semiconductor body under the electrodes 22, 23 and 42, 43, respectively, and 52, 53 and corresponding electrodes (Fig. 2e). This means that the charge packet 25 remains concentrated under the electrode 24, whereas the charge packet 20 is now present under the electrodes 21, 44. Thus, this charge packet is shifted through one electrode distance with respect to the situation at the instant $t_2'$.

At the instant $t_5 = 0.625 \mu\text{sec}$ (see Fig. 2f) potential barriers are present under the electrodes 22, 42, 52 and similar electrodes in the memory part. The charge packets 20 and 25 are now distributed under three electrodes (21, 44, 43) and two electrodes (24, 23), respectively. In this manner, the charge packet 20 is removed from the sensor prt 2 and is transferred to the memory part 3. Also from now on the charge packet 25 is transferred to the memory part under the influence of the clock pulse pattern.

The switching pattern described above is continued until at the instant t = 149.5 μsec the switching elements 88, 89 (Fig. 1) are switched so that the electrodes 83 and 84 are connected to the signal lines 14' and 17'. At that instant all electrodes both in the sensor part and in the memory part are controlled by means of the clock pulse pattern at the lines 14, 17, 16, 19, 14', 17', 16', 19'. In each of the transport channels 9, the charge packets, which were initially present under the electrodes 22, 24, 32, 34, ... 82, 84, are now effectively extended to a row of charge packets which extends substantially throughout the channel in both the sensor part and the memory part.

These charge packets are then transported to the memory part. Thus, the charge packet 20 is present at the instant t = 150.375 μsec under the electrodes 51, 52, while it is separated from charge packet 25 by a potential barrier under electrode 53 (see Fig. 2g).

In order to store the charge packets 20, 25, 30, 35 ... in the memory part, the transport electrodes in this part are brought successively to a fixed voltage. Thus, at the instant t = 150.5 μsec the switching elements 56 and 57 are changed over to the lines 15 and 18, which each have a fixed voltage. This results in that now a potential barrier is present under the electrode 52 so that the charge packet 20 is fixed in the potential well under the electrode 51 (see Fig. 2h). The clock pulse variation no longer influences this process, as appears from Figures 2i, 2j, 2k, which represent the situation at the area of the electrodes 51, 52, 53, 54 at the instants t = 150.625 µsec, t = 150.75 µsec and t = 150.875 µsec, respectively. At the instant t = 151 µsec, the electrodes 53 and 54 are brought *via* the switching elements 58 and 59 to the said fixed voltages so that the charge packet 25 is stored under the electrode 53. This procedure is continued until at the instant t = 300 µsec the original charge pattern from the sensor part 2 is stored entirely in the memory part 3, *i.e.* under the electrodes 51, 53, . . . 41, 43 due to the fact that these electrodes and the electrodes 52, 54, . . . 42, 44 are connected *via* the switching elements 56, 57, 58, 59, . . . 46, 47, 48, 49 to the lines 15, 15', 18 and 18', which each have a fixed voltage. This can be achieved *via* separate connection points 65, 68, 65' and 68' or *via* common connection points 75 and 78.

The electrodes in the sensor part can be controlled till this instant by the clock pulse signals described above and can then be connected to the reference lines 15, 18, 15', 18', wherein, like in the memory part, potential wells are introduced also in the image sensor part under the electrodes 21, 23, . . . 81, 83.

Alternatively, from the instant at which the charge packet originally generated under the electrode 84 has been distributed under the electrodes on the lefthand side of the electrode 82, the electrodes 83 and 84 may be connected *via* the switching elements 88 and 89 to the reference lines 15' and 18'. When the generated charge is further shifted to the memory part, an increasing number of electrodes are connected in the same manner to the reference lines 15, 18, 15', 18' and potential wells are formed under the electrodes 83, 81, . . . 23, 21.

This results in that in a next integration period the integration takes place under these electrodes instead of under the electrodes 84, 82 . . . 23, 22. In this manner, interlacing is possible.

During the integration period, information is transferred from the memory part to one or more output registers 4; this can be effected in that the electrodes 51, 52, 53, 54, . . . 41, 42, 43, 44 of the memory part are successively connected to the signal lines 16, 19, 16', 19', which are furnished with a clock pulse signal. For colour display purposes, three parallel-connected output registers are utilized, *i.e.* each for one of the colour components. The signals from the output registers 14 are amplified, if required, by means of amplifier 6.

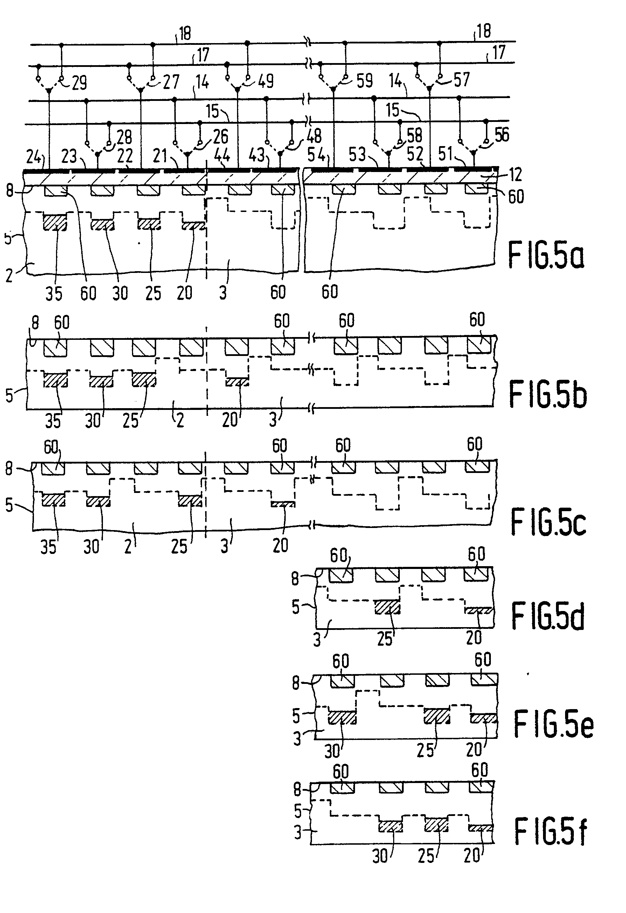

The device of Figures 4 and 5 comprises an image sensor device 1 suitable for two-phase transport. This device again has 600 electrodes in the sensor part 2 (of which Fig. 4 only shows the electrodes 21, 22, 23, 24, 81, 82, 83, 84) and 600 electrodes in the memory part 3 (of which only the electrodes 41, 42, 43, 44, 51, 52, 53, 54 are shown).

The electrodes 21, 23, 81 and 83 and corresponding electrodes in the sensor part may be switched by means of switching elements 26, 27, 86, 87, etc. between a reference line 15 and a line 14 to which a clock pulse may be supplied. In the same manner, the electrodes 41, 43, 51, 53 and corresponding electrodes of the memory part are switched between the reference line 15 and the line 14 by means of switching elements 46, 47, 56, 57.

In an analogous manner, electrodes 22, 24, 82, 84, 42, 44, 52, 54 are switched by means of switching elements 28, 29, 88, 89, 48, 49, 58, 59 between the line 17 (clock pulse) and the reference line 18. The switching elements 26, 27, 28, 29, . . . 86, 87, 88, 89 are controlled again by means of registers 13, 13', while for the reference lines 15, 18 voltages may be supplied at the junctions 65, 68. The clock pulse patterns are supplied at the junctions 64 and 67. In the present embodiment, the clock pulse lines for the sensor part and for the memory part are interconnected, if desired, the clock pulse voltages for the memory part may be separately at the junctions 66 and 69. These clock pulses may control, if desired, also the auxiliary electronic system for controlling the registers 13, 13'.

In the embodiment shown in Fig. 4, both the image sensor part and the memory part comprise 600 electrodes. As will be described hereinafter, charge can be integrated or stored simultaneously under each of these electrodes so that in an image sensor period double the number of image lines is integrated as compared with the device shown in Figures 1 and 2.

The operation of the image sensor device shown in Fig. 4 will now be described more fully with reference to Fig. 5.

Fig. 5a shows the situation in a part of a charge transport channel at the end of an integration period at an instant t = 0. The integration has taken place under all electrodes 21, 22, 23, 24, . . . 81, 82, 83, 84 of the sensor part 2. Due to the fact that under each of these electrodes an *n*-type implantation 60 has been provided, a potential well is present under each of these electrodes if they are connected *via* switching elements 26, 27, 28, 29, . . . 86, 87, 88, 89 to a fixed voltage at the signal lines 15, 18. The associated potential variation in the semiconductor body is again indicated by broken lines in Fig. 5a. After the integration period, the charge packets 20, 25, 30, 35 have been collected in the potential wells associated with the electrodes 21, 22, 23, 24.

The electrodes 41, 42, 43, 44, . . . 51, 52, 53, 54 are connected *via* switching elements 46, 47, 48, 49, . . . 56, 57, 58, 59 to the signal lines 14, 17, at which a two-phase clock is supplied. As a result, the potential variation in the righthand half of Fig. 5a has an appearance quite different from that in the lefthand half. The associated potential wells in the righthand half are assumed to contain no charge at the instant t = 0.

Fig. 5b shows the device at the instant $t_1 = 0.25$ µsec after the switching element 26 has been switched via the register 13 in such a manner that the electrode 21 is now connected to the clock line 14. Due to the associated potential variation, the charge packet 20 is displaced to a potential well under the electrode 44.

At the instant $t_2 = 0.5$ μsec, the electrode 22 is connected to the clock line 17. The potential variation consequently obtained in the subjacent semiconductor body is now (see Fig. 5c) identical in the righthand half of the semiconductor body to that at the instant $t = 0$, while the charge packets 20 and 25 are displaced to potential wells under the electrodes 43 and 21, respectively.

In the same manner as described with reference to the four-phase device of Figures 1 and 2, the electrodes 23, 24, ... 81, 82, 83, 84 are then connected one by one to the clock lines 14, 17. As a result, the charge packets are transported in the direction of the memory part. At the instant $t = 150$ μsec, the charge packet 20 has arrived under the electrode 51 (see Fig. 5d), while the charge packet 25 is present under the electrode 53. At that instant, all electrodes are connected to the clock lines 14, 17.

At the instant $t = 150.5$ μsec, the electrode 51 is connected *via* the switching element 56 to a fixed voltage at the reference line 15 (see Fig. 5e). From that instant, the charge packet 20 is held under the electrode 51. In the same manner, from $t = 151$ μsec, the charge packet 25 is held under the electrode 52 (see Fig. 5f). The remaining electrodes of the memory part are now successively connected to the reference lines 15, 18 until at the instant $t = 300$ μsec potential wells are present under all electrodes in the memory part, in which wells a charge pattern is stored identical to that in the sensor part at the instant $t = 0$.

The information stored in the memory part can be transferred again gradually to the reading-out register 4. These registers are now preferably of double construction, in which the 600 lines are read out alternately *via* a register for odd lines and a register for even lines. The signals supplied by the registers 4 are amplified again, if required, by means of amplifiers 6.

If desired, the device may also be used for recording each time one scene, in which event after one integration the information is read out and is recorded on an information carrier, such as a magnetic tape. In this case, the information need not be stored in a memory part, but can be transferred directly from the sensor part 2 *via* a reading-out register to, for example, an information-processing unit.

The invention may also be used in a device for multiple interlacing, in which the number of electrodes in the sensor part and in the memory part are then adapted to each other in such a manner that with 1:n interlacing, the image sensor part comprises a number of electrodes n/2 times that of the memory part so that the memory part need comprise only 2/n times the number of electrodes of the image sensor part. Besides, the principle of the invention can also be utilized in a series/parallel/series memory (SPS-memory) which comprises several adjacent charge transport channels and in which information is first serially read into an input register, whose content is each time transferred in parallel to the charge transport channels in which the information is displaced in parallel and can again be read out serially *via* a reading-out register. When it is ensured that herein the transport and the storage take place in the parallel part in the way described above, the information density therein can be doubled. Thus, in a device for a two-phase clock, an information bit can be stored in each channel under each electrode. The principle of the invention can also be applied in other charge-coupled devices, in which stored charge should be temporarily stored, for example, if such a device is used as a delay line and the information should be read out in the form of stored charge at a later instant or if several of such devices are arranged in a multiplex circuit arrangement, in which the information can be read out arbitrarily from one of the charge-coupled devices.

**Claims**

1. A charge-coupled semiconductor device comprising a semiconductor body in which at a major surface at least one charge transport channel is defined and which is provided at the same major surface with a system of electrodes at which a reference signal can be supplied for charge storage and a clock signal can be supplied for charge transport, characterized in that the semiconductor body is provided with switching elements by means of which either the reference signal or the clock signal can be supplied at separate groups of at least one electrode.

2. A charge-coupled image sensing device for collecting a radiation image and for converting it into an electric signal, comprising a semiconductor body in which at a major surface several charge transport channels are defined for charge transport from a radiation-sensitive part to an output circuit or a processing unit, the semiconductor body being provided at the same major surface with a system of electrodes at which a reference signal can be supplied for charge storage and a clock signal can be supplied for charge transport, characterized in that the semiconductor body is provided with switching elements by which either the reference signal or the clock signal can be supplied at separate groups of at least one electrode.

3. A charge-coupled image sensing device for collecting a radiation image and converting it into an electric signal comprising a semiconductor body in which at a major surface are defined a number of mutually separated charge transport channels for charge transport from a radiation-sensitive part to a memory part, the semiconductor body being provided at the same major surface with a system of electrodes at which a reference signal can be supplied for charge storage and a clock signal can be supplied for charge transport, characterized in that the semiconductor body is provided with switching elements by means of which either the reference signal or the clock signal can be supplied at separate groups of at least one electrode.

4. A charge-coupled semiconductor device as claimed in any one of the preceding Claims, characterized in that the reference signal produces under at least a part of the electrodes a potential variation of potential barriers and potential wells repeated per $n$ electrodes, $n \geq 1$ and the clock signal produces under at least a part of the electrodes a potential variation of potential barriers and potential wells repeated per $m$ electrodes, $m > n$.

5. A device as claimed in any one of the preceding Claims, characterized in that a switching element comprises a MOS transistor.

6. A device as claimed in any one of Claims 1 to 5, characterized in that the switching elements are controlled from registers.

7. A device as claimed in any one of Claims 1 to 6, characterized in that the reference signal is variable.

8. An image sensing device as claimed in Claim 2 or 3, for two-phase transport, characterised in that the image sensor device has at least one reading-out register of double construction.

9. An image sensing device as claimed in any one of Claims 2 to 8, characterized in that the elements for controlling the switching elements, reading and amplifying are formed in the same semiconductor body.

10. An image sensing device as claimed in any one of Claims 3 to 9, characterized in that for 1:n interlacing the radiation-sensitive part has a number of electrodes n/2 times the number of transport electrodes of the memory part.

**Patentansprüche**

1. Ladungsgekoppelte Halbleiteranordnung mit einem Halbleiterkörper, in dem an einer Hauptfläche wenigstens ein Ladungstransportkanal definiert ist und der an derselben Hauptfläche mit einem System von Elektroden versehen ist, dem ein Bezugssignal zur Ladungsspeicherung und ein Taktimpulssignal zum Ladungstransport zugeführt werden kann, dadurch gekennzeichnet, dass der Halbleiterkörper mit Schaltelementen versehen ist, mit deren Hilfe das Bezugssignal oder das Taktimpulssignal einzelnen Gruppen von wenigstens einer Elektrode zugeführt werden kann.

2. Ladungsgekoppelte Bildsensoranordnung zum Ansammeln eines Strahlungsbildes und zum Umwandeln dieses Bildes in ein elektrisches Signal, mit einem Halbleiterkörper in dem an einer Hauptfläche mehrere Ladungstransportkanäle definiert sind zum Ladungstransport von einem strahlungsempfindlichen Teil zu einer Ausgangsschaltung oder zu einer Verarbeitungseinheit, wobei der Halbleiterkörper an derselben Hauptfläche mit einem Elektrodensystem versehen ist, dem ein Bezugssignal zur Ladungsspeicherung und ein Taktimpulssignal zum Ladungstransport zugeführt werden kann, dadurch gekennzeichnet, dass der Halbleiterkörper mit Schaltelementen versehen ist, durch die das Bezugssignal oder das Taktimpulssignal einzelnen Gruppen von wenigstens einer Elektrode zugeführt werden kann.

3. Ladungsgekoppelte Bildsensoranordnung zum Ansammeln eines Strahlungsbildes und zum Umwandeln dieses Bildes in ein elektrisches Signal mit einem Halbleiterkörper, in dem an einer Hauptfläche eine Anzahl voneinander getrennter Ladungstransportkanäle für die Ladungstransport von einem strahlungsempfindlichen Teil zu einem Speicherteil definiert sind, wobei der Halbleiterkörper auf derselben Hauptfläche mit einem Elektrodensystem versehen ist, dem ein Bezugssignal zur Ladungsspeicherung und ein Taktimpulssignal zum Ladungstransport zugefürt werden kann, dadurch gekennzeichnet, dass der Halbleiterkörper mit Schaltelementen versehen ist, durch die entweder das Bezugssignal oder das Taktimpulssignal einzelnen Gruppen von wenigstens einer Elektrode zugeführt werden kann.

4. Ladungsgekoppelte Halbleiteranordnung nach einem der vorstehenden Ansprüche, dadurch gekennzeichnet, dass das Bezugssignal unter wenigstens einem Teil der Elektroden einen Potentialverlauf von Potentialsperren und Potentialpfützen, die je n Elektroden wiederholt werden, erzeugt, wobei n > 1 ist und das Taktimpulssignal unter wenigstens einem Teil der Elektroden einen Potentialverlauf von Potentialsperren und Potentialpfützen, die je m Elektroden wiederholt werden, erzeugt, wobei m > n ist.

5. Anordnung nach einem for vorstehenden Ansprüche, dadurch gekennzeichnet, dass ein Schaltelement einem MOS-Transistor aufweist.

6. Anordnung nach einem der Ansprüche 1 bis 5, dadurch gekennzeichnet, dass die Schaltelemente aus Registern gesteuert werden.

7. Anordnung nach einem der Ansprüche 1 bis 6, dadurch gekennzeichnet, dass das Bezugssignal veränderlich ist.

8. Bildsensoranordnung nach Anspruch 2 oder 3, für Zweiphasentransport, dadurch gekennzeichnet, dass die Bildsensoranordnung wenigstens ein Ausleseregister einer doppelten Konstruktion aufweist.

9. Bildsensoranordnung nach einem der Ansprüche 2 bis 8, dadurch gekennzeichnet, dass die Elemente zur Steuerung der Schaltelemente, zum Auslesen und Verstärken in demselben Halbleiterkörper gebildet werden.

10. Bildsensoranordnung nach einem der Ansprüche 3 bis 9, dadurch gekennzeichnet, dass für ein 1:n-Zeilensprungverfahren der strahlungsempfindliche Teil ein Anzahl Elektroden aufweist, die der n/2-fachen Anzahl der Transportelektroden des Speicherteils entspricht.

**Revendications**

1. Dispositif semiconducteur à couplage de charges comportant un corps semiconducteur dans lequel, à une surface principale, est défini au moins un canal de transport de charges et qui, à la même surface principale, est muni d'un système d'électrodes auquel peuvent être fournis un signal de référence pour le stockage de charges et un signal d'horloge pour le transport de charges, caractérisé en ce que le corps semiconducteur est muni d'éléments de commutation au moyen desquels, soit le signal de référence, soit le signal d'horloge peut être appliqué à des groupes séparés d'au moins une électrode.

2. Dispositif à couplage de charges capteur d'images servant à capter une image de rayonnement et à la convertir en un signal électrique et comportant un corps semiconducteur dans lequel, à une surface principale, sont dèfinis plusieurs canaux de transport de charges pour transporter des charges à un circuit de sortie ou à une unité de traitement, le corps semiconducteur étant muni, à la même surface principale, d'un système d'électrodes auquel peuvent être appliqués un signal de référence pour le stockage de charges et un signal d'horloge pour le transport de charges, caractérisé en ce que le corps semiconducteur est muni d'éléments de commutation au moyen desquels, soit le signal de référence, soit le signal d'horloge peut être appliqué à des groupes séparés d'au moins une électrode.

3. Dispositif à couplage de charges capteur d'images servant à capter une image de rayonnement et à la convertir en un signal électrique et comportant un corps semiconducteur dans lequel, à une surface principale, sont définis plusieurs canaux de transport de charges séparés les uns des autres pour transporter des charges à partir d'une partie sensible au rayonnement vers une partie de mémorisation, le corps semiconducteur étant muni, à la même surface principale, d'un système d'électrodes auquel peuvent être appliqués un signal de référence pour le stockage de charges et un signal d'horloge pour le transport de charges, caractérisé en ce que le corps semiconducteur est muni d'éléments de commutation au moyen desquels, soit le signal de référence, soit le signal d'horloge peut être appliqué à des groupes séparés d'au moins une électrode.

4. Dispositif semiconducteur à couplage de charges selon l'une quelconque des revendications précédentes, caractérisé en ce que le signal de référence provoque au-dessous d'au moins une partie des électrodes une variation de potentiel de barrières de potentiel et de puits de potentiel se répétant toutes les n électrodes, n ≥ 1, et en ce que le signal d'horloge provoque audessous d'au moins une partie des électrodes une variation de potentiel de barrières de potentiel et de puits de potentiel se répétant toutes les m électrodes, m > n.

5. Dispositif selon l'une quelconque des revendications précédentes, caractérisé en ce qu'un élément de commutation comporte un transistor MOS.

6. Dispositif selon l'une quelconque des revendications 1 à 5, caractérisé en ce que les éléments de commutation sont commandés à partir de registres.

7. Dispositif selon l'une quelconque des revendications 1 à 6, caractérisé en ce que le signal de référence est variable.

8. Dispositif capteur d'images selon la revendication 2 ou 3, servant au transport à deux phases, caractérisé en ce que le dispositif capteur d'images comporte au moins un registre de lecture de réalisation double.

9. Dispositif capteur d'images selon l'une quelconque des revendications 2 à 8, caractérisé en ce que les éléments de commande des éléments de commutation, de lecture et d'amplification sont réalisés dans le même corps semiconducteur.

10. Dispositif capteur d'images selon l'une quelconque des revendications 3 à 9, caractérisé en ce que pour un entrelacement de 1:n, la partie sensible au rayonnement présente un nombre d'électrodes n/2 fois plus grand que le nombre d'électrodes de transport de la partie de mémorisation.

FIG.1

0 128 615

FIG.2a

FIG.2b

FIG.2c

FIG.2d

2

FIG.2e

FIG.2f

FIG.2g

FIG.2h

FIG.2i

FIG.2j

FIG.2k

0 128 615

FIG. 3

FIG. 4

4

FIG.5a

FIG.5b

FIG.5c

FIG.5d

FIG.5e

FIG.5f